**Europäisches Patentamt**

**European Patent Office**

**Office européen des brevets**

(19)

(11) Veröffentlichungsnummer: **0 065 174**
**B1**

(12) ## EUROPÄISCHE PATENTSCHRIFT

(45) Veröffentlichungstag der Patentschrift:
**11.05.88**

(21) Anmeldenummer: **82103785.0**

(22) Anmeldetag: **03.05.82**

(51) Int. Cl.⁴: **H 01 L 29/743,** H 01 L 29/08,
H 01 L 29/52

(54) **Verfahren zum Betrieb eines Thyristors mit steuerbaren Emitterkurzschlüssen.**

(30) Priorität: **08.05.81 DE 3118354**

(43) Veröffentlichungstag der Anmeldung:
**24.11.82 Patentblatt 82/47**

(45) Bekanntmachung des Hinweises auf die Patenterteilung:
**11.05.88 Patentblatt 88/19**

(84) Benannte Vertragsstaaten:
**CH FR GB IT LI SE**

(56) Entgegenhaltungen:
**EP - A - 0 008 008**
**EP - A - 0 030 274**
**DE - A - 1 211 334**
**DE - A - 2 163 922**
**DE - A - 2 625 917**

(73) Patentinhaber: **Siemens Aktiengesellschaft Berlin und München, Wittelsbacherplatz 2, D-8000 München 2 (DE)**

(72) Erfinder: **Stoisiek, Michael, Dr., Robert-Koch-Strasse 24, D-8012 Ottobrunn (DE)**

## Beschreibung

Die Erfindung bezieht sich auf ein Verfahren zum Betrieb eines Thyristors mit einem Halbleiterkörper, der einen von einer Kathode kontaktierten n-Emitter mit einer angrenzenden p-Basisschicht und einen von einer Anode kontaktierten p-Emitter mit einer angrenzenden n-Basisschicht aufweist, und mit an einer Grenzfläche des Halbleiterkörpers angeordneten, als MIS-Strukturen ausgebildeten, steuerbaren Emitterkurzschlüssen, jeweils bestehend aus einem ersten Halbleitergebiet eines ersten Leitungstyps, das mit der den einen Emitter kontaktierenden Kathode oder Anode elektrisch verbunden ist, einem mit der an diesen Emitter angrenzenden Basisschicht elektrisch verbundenen zweiten Halbleitergebiet des ersten Leitungstyps und einem zwischen diesen Halbleitergebieten liegenden Halbleiterbereich eines zweiten Leitungstyps, der von einem gegenüber dem Halbleiterkörper elektrisch isolierten Gate überdeckt ist, wobei der letztgenannte Emitter in eine Mehrzahl von Emittergebieten aufgeteilt ist und wobei eine Mehrzahl von MIS-Strukturen jeweils randseitig zu den Emittergebieten angeordnet sind und die Gates über einen Steueranschluss mit einem die Emitterkurzschlüsse aufhebenden Spannungsimpuls beschaltbar sind.

In der EP-A-0 030 274, die gemäss Artikel 54 (3) EPÜ zum Stand der Technik gehört, ist ein solches Verfahren angegeben, bei dem dem Steueranschluss von randseitig zu den Emittergebieten des n-Emitters (p-Emitters) angeordneten MIS-Strukturen des Verarmungstyps ein die Umschaltung des Thyristors aus dem blockierten Zustand in den stromführenden Zustand veranlassender positiver (negativer) Spannungsimpuls zugeführt wird. Dabei sind die ersten Halbleitergebiete der MIS-Strukturen jeweils derart in die einzelnen Emittergebiete eingefügt, dass sie sich bis zur Grenzfläche des Halbleiterkörpers erstrecken, in der sie mit Teilen der Kathode bzw. Anode leitend verbunden sind, wobei die zweiten Halbleitergebiete der MIS-Strukturen jeweils aus Zonen der an diese Emittergebiete angrenzenden Basisschicht bestehen, die sich ebenfalls bis an die Grenzfläche erstrecken, und wobei die zwischen den ersten und zweiten Halbleitergebieten liegenden Halbleiterbereiche jeweils aus den Teilen der Emittergebiete bestehen, die sich zwischen den einander gegenüberliegenden Grenzflächen der Zonen der Basisschicht und der ersten Halbleitergebiete befinden. Gehören die MIS-Strukturen dem Verarmungstyp an, so werden ihre Gates spannungslos gehalten, um den blockierten Zustand des Thyristors aufrecht zu erhalten. Durch Zuführung eines Spannungsimpulses der obengenannten Polarität werden die Emitterkurzschlüsse dann unwirksam geschaltet, so dass die Zündung des Thyristors erfolgt. Bei MIS-Strukturen des Anreicherungstyps liegen die Gates im blockierten Zustand des Thyristors an einer ständigen Vorspannung, die durch den genannten Spannungsimpuls aufgehoben oder überkompensiert wird, so dass die Zündung erfolgt.

Ist bei dem der EP-A-0 030 274 entnehmbaren Verfahren die eine Basisschicht des Thyristors mit einer Zündelektrode versehen, die einen Anschluss aufweist, der sowohl mit einem Zündstromkreis als auch mit den Gates der MIS-Strukturen verbunden ist, so wird ein an dem Anschluss der Zündelektrode abgreifbarer Zündspannungsimpuls zur Unwirksamschaltung der Emitterkurzschlüsse herangezogen.

Der Erfindung liegt die Aufgabe zugrunde, ein Verfahren der eingangs angedeuteten Art anzugeben, das auf eine einfache und leicht herstellbare Ausführungsform eines mit steuerbaren Emitterkurzschlüssen versehenen Thyristors anwendbar ist.

Das wird erfindungsgemäss dadurch erreicht, dass bei einem Thyristor, bei dem das erste Halbleitergebiet einer MIS-Struktur aus einem Randbereich eines Emittergebietes besteht, wobei das zweite Halbleitergebiet aus einem in die an dieses Emittergebiet angrenzende Basisschicht eingefügten Kurzschlussgebiet gebildet ist, das über eine leitende Belegung mit dieser Basisschicht verbunden ist, und wobei der von dem Gate überdeckte Halbleiterbereich aus einem Teilbereich der letztgenannten Basisschicht besteht, der bis an die das Emittergebiet enthaltende Grenzfläche des Halbleiterkörpers reicht, so vorgegangen wird, dass dem Steueranschluss der randseitig zu den Emittergebieten angeordneten MIS-Strukturen ein die Emitterkurzschlüsse während des Zündvorgangs aufhebender Spannungsimpuls zugeführt wird, und dass dieser Spannungsimpuls für den Fall, dass der genannte eine Emitter aus dem n-Emitter besteht, als negativer Impuls und für den Fall, dass der genannte eine Emitter aus dem p-Emitter besteht, als positiver Impuls zugeführt wird.

Gemäss weiterer Erfindung ist das Verfahren bei einem Thyristor, bei dem diejenige Basisschicht, die an die mit ihren Randbereichen die ersten Halbleitergebiete der MIS-Strukturen bildenden Emittergebiete angrenzt, mit einer Zündelektrode versehen ist, die einen Anschluss für einen Zündstromkreis aufweist, wobei der Anschluss für den Zündstromkreis über eine Polaritätsumkehrschaltung mit dem Steueranschluss der MIS-Strukturen verbunden ist, in der Weise ausgebildet, dass eine am Anschluss für den Zündstromkreis bei Zuführung eines Zündstromimpulses abfallende Zündspannung umgepolt und dem Steueranschluss der MIS-Strukturen als ein die Emitterkurzschlüsse aufhebender Spannungsimpuls zugeführt wird.

Der mit dem Verfahren nach der Erfindung erzielbare Vorteil besteht insbesondere darin, dass dieses auf einen Thyristor anwendbar ist, bei dem die Herstellung der für die steuerbaren Emitterkurzschlüsse erforderlichen Kurzschlussgebiete im Rahmen derjenigen Dotierungsschritte erfolgt, die bereits zur Herstellung der einzelnen Halbleitergebiete bzw. -schichten des Thyristors benötigt werden, so dass der Mehraufwand für die steuerbaren Emitterkurzschlüsse sehr klein gehalten werden kann.

Aus der US-A-3 243 669, vgl. insbesondere Fig. 9, und der DE-A-2 625 917 sind Thyristoren mit als MIS-Strukturen ausgebildeten, steuerbaren Emitterkurzschlüssen bekannt, die lediglich zum Zwecke eines schnellen Löschens der Thyristoren wirksam geschaltet werden. Zu den hieraus bekannten, steuerbaren Emitterkurzschlüssen gehören jeweils ein erstes Halbleitergebiet eines ersten Leitungstyps, das aus einem Randbereich des n(p)-Emitters besteht, ferner ein zweites Halbleitergebiet, desselben Leitungstyps, das im Abstand vom n(p)-Emitter in die an diesen angrenzende Basisschicht eingefügt ist, und der zwischen diesen Halbleitergebieten liegende, einen zweiten Leitungstyp aufweisende Teilbereich der Basisschicht, der von einem isolierten Gate überdeckt ist. Aus der DE-A-2 625 917 ist es auch bekannt, diese Emitterkurzschlüsse während des Auftretens eines Zündimpulses wirksam zu schalten, um eine Zündung zu verhindern. Steuerbare Emitterkurzschlüsse, die vor dem Zünden des Thyristors als Stabilisierungskurzschlüsse dienen und insbesondere unabhängig vom Auftreten einer Blockierspannung wirksam geschaltet sind, während sie beim Zündvorgang unwirksam geschaltet sind, lassen sich jedoch hieraus nicht entnehmen.

Nachfolgend wird die Erfindung anhand der Zeichnung näher erläutert. Dabei zeigt:

Fig. 1 ein erstes Ausführungsbeispiel der Erfindung,

Fig. 2 ein Spannungs-Zeit-Diagramm zur Erläuterung von Fig. 1,

Fig. 3 ein zweites Ausführungsbeispiel und

Fig. 4 ein Spannungs-Zeit-Diagramm zur Erläuterung von Fig. 3.

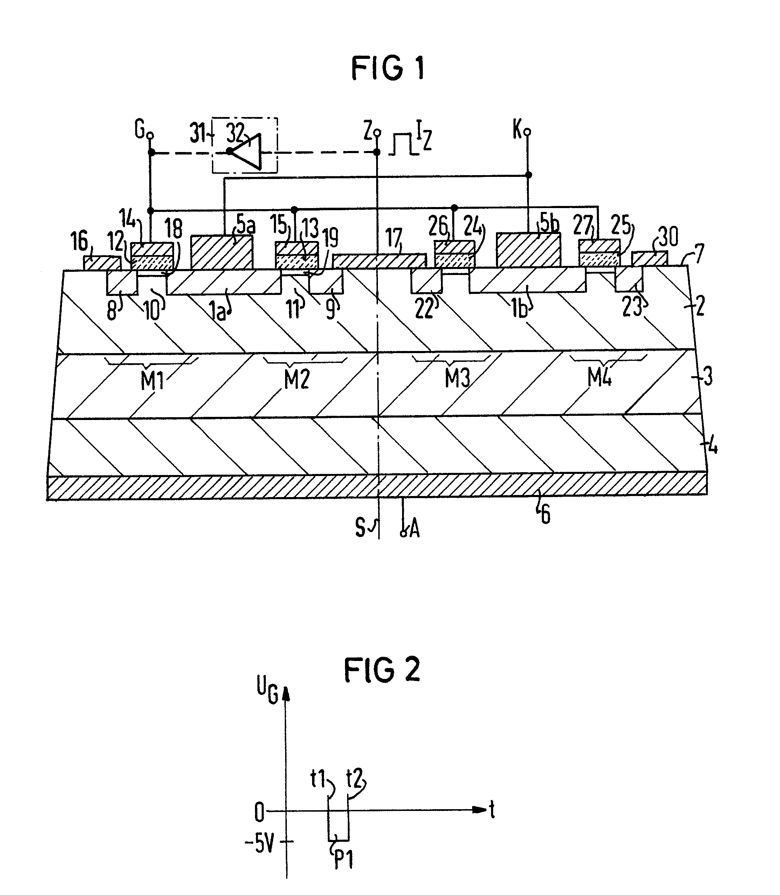

Der Thyristor nach Fig. 1 besteht aus einem Körper aus dotiertem Halbleitermaterial, z.B. Silizium, der mehrere aufeinanderfolgende Schichten abwechselnder Leitungstypen aufweist. Mit 1a und 1b sind zwei n-Emittergebiete bezeichnet, die Teile eines n-Emitters darstellen. An diese grenzt eine p-Basisschicht 2, unter der sich eine n-Basisschicht 3 und ein ebenfalls schichtförmiger p-Emitter 4 befinden. Die n-Emittergebiete 1a und 1b werden von Teilen 5a und 5b einer aus elektrisch leitendem Material, z.B. Aluminium, bestehenden Kathode kontaktiert, die mit einem gemeinsamen Anschluss K verbunden sind, während der p-Emitter 4 von einer aus elektrisch leitendem Material, z.B. Aluminium, bestehenden Anode 6 kontaktiert wird, die einen Anschluss A aufweist. Die n-Emittergebiete 1a, 1b sind so in die p-Basisschicht 2 eingefügt, dass sie sich bis zur Grenzfläche 7 des Halbleiterkörpers erstrecken.

Randseitig zu dem n-Emittergebiet 1a sind n-leitende Kurzschlussgebiete 8 und 9 derart in die p-Basisschicht 2 eingefügt, dass sie sich ebenfalls bis zur Grenzfläche 7 erstrecken. Dabei können die Gebiete 1a, 1b, 8 und 9 mit besonderem Vorteil durch ein- und denselben Dotierungsschritt hergestellt werden. Die Teilbereiche 10 und 11 der p-Basisschicht 2, die mit ihrer Breite den Abstand der Gebiete 8 und 9 von dem n-Emittergebiet 1a bestimmen, sind von dünnen elektrisch isolierenden Schichten 12 und 13 überdeckt, auf denen Gates 14 und 15 angeordnet sind. Diese bestehen aus elektrisch leitendem Material, z.B. aus hochdotiertem polykristallinen Silizium, und sind mit einem gemeinsamen Steueranschluss G verbunden. Leitende Belegungen 16, 17 überbrücken die pn-Übergänge zwischen der p-Basisschicht 2 und den Kurzschlussgebieten 8 und 9 an den von den Teilbereichen 10 und 11 abgewandten Rändern der letzteren. Der linke Randbereich des n-Emittergebiets 1a stellt ein erstes und das Kurzschlussgebiet 8 ein zweites n-leitendes Halbleitergebiet einer MIS-Struktur M1 dar, zu der auch der p-leitende Teilbereich 10 mit einen n-leitenden Kanal 18 an der Grenzfläche 7, die isolierende Schicht 12 und das Gate 14 gehören. In analoger Weise stellt der rechte Randbereich von 1a zusammen mit den Teilen 9, 11, 13 und 15 eine MIS-Struktur M2 dar, deren mit 19 bezeichneter n-Kanal im Teilbereich 11 an der Grenzfläche 7 verläuft.

Die n-Kanäle 18 und 19 sind bei spannungslosem Steueranschluss G vorhanden, was durch eine Ausbildung der Strukturen M1 und M2 als solche des Verarmungstyps erreicht wird. Bei den n-Kanälen 18, 19 handelt es sich entweder um Inversionskanäle, die durch ein an der Grenzfläche 7 bestehendes, die Teilbereiche 10 und 11 beeinflussendes elektrisches Feld aufgebaut worden sind, oder um dotierte Kanalgebiete, die durch eine flache n-Dotierung unmittelbar an der Grenzfläche 7 erzeugt sind. Führt man dem Steueranschluss G eine hinreichend grosse negative Spannung zu, so werden die Kanäle 18, 19 jeweils beseitigt bzw. hochohmig geschaltet.

Die Struktur M1 bildet somit einen Schalter, der in einem ersten Schaltzustand (spannungsloser Steueranschluss G) das n-Emittergebiet 1a mit den Kurzschlussgebieten 8, 9 und weiterhin über die Belegungen 16, 17 auch mit der p-Basisschicht 2 niederohmig verbindet. In einem zweiten Schaltzustand (negative Spannung an G) wird diese niederohmige Verbindung dann unterbrochen bzw. hochohmig geschaltet. Somit stellt die Struktur M1 einschliesslich der leitenden Belegung 16 einen ersten und die Struktur M2 einschliesslich der leitenden Belegung 17 einen zweiten steuerbaren Emitterkurzschluss des Thyristors dar.

Randseitig zu dem n-Emittergebiet 1b sind in analoger Weise weitere Kurzschlussgebiete 22 und 23 vorgesehen, die zusammen mit elektrisch isolierenden Schichten 24, 25, Gates 26, 27 und den Randbereichen von 1b gleichartig aufgebaute MIS-Strukturen M3 und M4 bilden. Die Gates 26 und 27 sind ebenfalls mit dem Steueranschluss G verbunden. Die leitende Belegung 17 ist in Fig. 1 soweit nach rechts verlängert, dass sie auch den pn-Übergang zwischen dem Kurzschlussgebiet 22 und der p-Basisschicht 2 kurzschliesst, während eine leitende Belegung 30 den pn-Übergang zwischen den Teilen 23 und 2 niederohmig überbrückt. Dabei stellt die Struktur M3 zusammen mit der Belegung 17 einen dritten und die Struktur M4 zusammen mit der Belegung 30 einen vierten steuerbaren Emitterkurzschluss dar. Die leitende Belegung 17 ist in Fig. 1 mit einem Anschluss Z eines Zündstromkreises verbunden.

Im Betrieb ist der Steueranschluss G des Thyristors nach Fig. 1 jeweils vor dem Zündzeitpunkt von Spannungen freigeschaltet. Dabei sind die n-Emittergebiete 1a und 1b über die steuerbaren Emitterkurzschlüsse M1, 16; M2, 17; M3, 17 und M4, 30 mit der p-Basisschicht 2 jeweils niederohmig verbunden. Hierdurch wird eine Stabilität des Thyristors gegenüber unbeabsichtigten Zündvorgängen gewährleistet. Die steuerbaren Emitterkurzschlüsse werden daher als Stabilisierungskurzschlüsse bezeichnet.

Die Stabilität kann noch erhöht werden, wenn eine Vielzahl von n-Emittergebieten 1a, 1b ... mit einer Vielzahl von MIS-Strukturen M1, M2, M3, M4 ... versehen werden, die sich über die Grenzfläche 7 des Thyristors möglichst gleichmässig verteilen. Zum Zünden des Thyristors wird dem Anschluss Z ein Zündstromimpuls $I_Z$ zugeführt. Gleichzeitig wird der Steueranschluss G für die Dauer des Zündvorgangs mit einem negativen Spannungsimpuls P1 beaufschlagt, der die n-Kanäle 18, 19 usw. jeweils unterbricht und damit die Stabilisierungskurzschlüsse während des gesamten Zündvorgangs unwirksam schaltet. Damit wird die Zündempfindlichkeit des Thyristors wesentlich erhöht. Fig. 2 zeigt den zeitlichen Verlauf der Spannung $U_G$, die dem Steueranschluss G im Betrieb zugeführt wird. Wie hieraus hervorgeht, bleibt G spannungslos bis auf ein Zeitintervall t1 bis t2, in dem der Zündvorgang abläuft. In diesem Zeitintervall liegt ein Spannungsimpuls P1 von z.B. −5V an G. Nach erfolgter Zündung fliesst ein Laststrom eines bei A und K angeschlossenen Laststromkreises über den niederohmig geschalteten Thyristor. Die Abschaltung des letzteren wird durch eine Abschaltung der zwischen A und K anliegenden Spannung oder bei einer anliegenden Wechselspannung durch den nächstfolgenden Nulldurchgang derselben erreicht.

Der negative Spannungsimpuls P1 kann mit Vorteil über eine Polaritätsumkehrschaltung 31 aus der Zündspannung abgeleitet werden, die bei Zuführung von $I_Z$ am Anschluss Z auftritt. Die Polaritätsumkehrschaltung 31 besteht z.B. aus einem invertierenden Verstärker 32, dessen Eingang mit Z und dessen Ausgang mit G beschaltet ist. Beim Auftreten eines positiven Steuerstromimpulses $I_Z$ ist dann am Ausgang von 32 der negative Spannungsimpuls P1 abgreifbar.

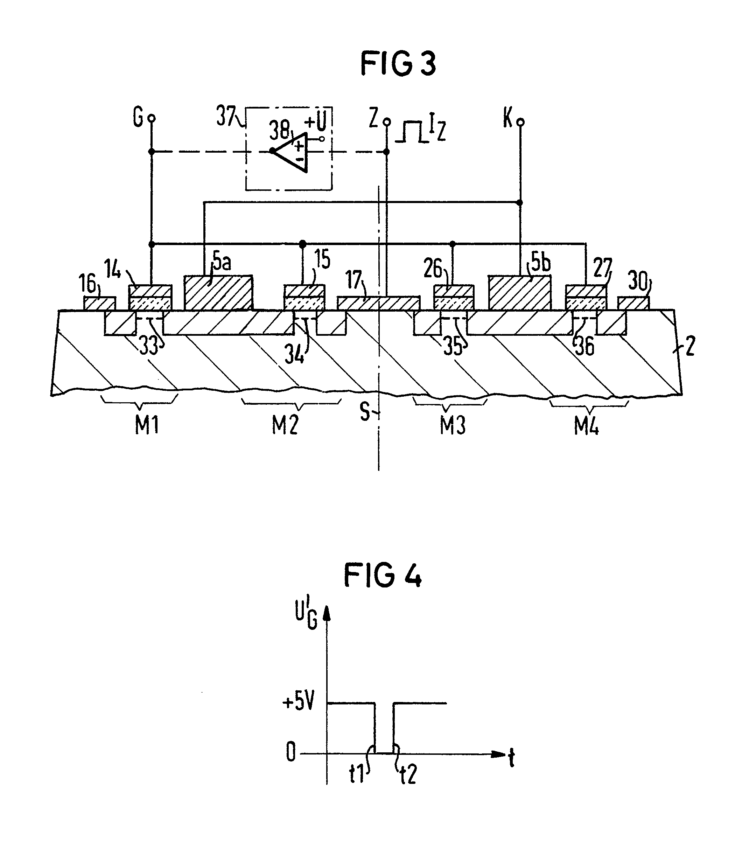

Fig. 3 zeigt ein zweites Ausführungsbeispiel der Erfindung, bei dem im Unterschied zu Fig. 1 die MIS-Strukturen M1 bis M4 als solche des Anreicherungstyps ausgebildet sind. Hierbei wird dem Steueranschluss G vor dem Zündzeitpunkt, d.h. also im blockierten Zustand des Thyristors, eine positive Spannung $U_G'$ zugeführt, um n-leitende Inversionskanäle 33 bis 36 unterhalb der Gates 14, 15, 26 und 27 zu erzeugen und die Stabilisierungskurzschlüsse somit wirksam zu schalten. Lediglich während des Zündvorgangs, d.h. im Zeitintervall t1 bis t2, wird die Spannung $U_G'$ unterbrochen. Die Unterbrechung von $U_G'$ im Zeitintervall t1 bis t2 kann als ein negativer Spannungsimpuls aufgefasst werden, der sich dem ausserhalb dieses Zeitintervalls bestehenden Pegel von $U_G'$ überlagert. Der zeitliche Verlauf der Spannung $U_G'$ ist in Fig. 4 dargestellt. Die Spannung $U_G'$ kann mit Vorteil aus der Zündspannung abgeleitet werden, die am Anschluss Z auftritt. Hierzu dient eine Polaritätsumkehrschaltung 37, die auch eine Pegelverschiebung bewirkt. Sie besteht beispielsweise aus einem Differenzverstärker 38, dessen positiver Eingang mit einer Spannung +U beschaltet ist, die der Amplitude der an Z auftretenden Zündspannung entspricht. Der negative Eingang von 38 liegt an Z, während der Ausgang von 38 mit dem Steueranschluss G verbunden ist. Hierbei liegt am Ausgang des Differenzverstärkers eine positive Spannung, die nur während des Auftretens eines Zündstromimpulses $I_Z$ unterbrochen wird.

Die n-Emittergebiete 1a, 1b ... können beispielsweise streifenförmig ausgebildet sein und über die Grenzfläche 7 geradlinig verlaufen, wobei ihre längeren Abmessungen senkrecht zur Zeichenebene von Fig. 1 bzw. Fig. 3 liegen. Andererseits können die n-Emittergebiete auch kreisringförmig ausgebildet sein, wobei sich ein rotationssymmetrischer Aufbau des Thyristors um die Achse S ergibt. Die in Fig. 1 und Fig. 3 eingezeichneten Verbindungen der Teile 5a und 5b sowie der Gates 15 und 26 entfallen hierbei.

Anstelle des n-Emitters kann auch der p-Emitter in einzelne p-Emittergebiete aufgeteilt sein, die von einzelnen, untereinander leitend verbundenen Teilen der Anode kontaktiert werden. Hierbei sind dann steuerbare p-Emitterkurzschlüsse vorhanden. Die Figuren können zur Darstellung dieser Variante herangezogen werden, wenn die Bezeichnungen der Anschlüsse A und K miteinander vertauscht werden, die dargestellten Halbleitergebiete die jeweils entgegengesetzten Leitfähigkeiten zu den bisher beschriebenen aufweisen und die Spannungen bzw. Spannungsimpulse mit jeweils entgegengesetzten Polaritäten zugeführt werden. Schliesslich kann auch eine eigene Zündelektrode auf einem Teil der p-Basisschicht vorgesehen sein und anstelle der Belegung 17 mit dem Anschluss Z des Zündstromkreises verbunden werden. Eine weitere Möglichkeit besteht darin, eine der leitenden Belegungen 16 oder 30 als Zündelektrode zu verwenden.

Die Eindringtiefe der n-Emittergebiete 1a und 1b sowie der Kurzschlussgebiete 8, 9, 22 und 23 in die p-Basisschicht 2 kann beispielsweise 3 μm betragen. Hierbei kommen dann für die Abstände der Kurzschlussgebiete 8, 9 von dem zugeordneten n-Emittergebiet 1a z.B. jeweils 5 μm in Betracht. Die lateralen Abmessungen der Kurzschlussgebiete 8, 9 usw. in der Bildebene von Fig. 1 können z.B. jeweils 10 μm betragen.

Der Halbleiterkörper des Thyristors nach den Figuren 1 oder 3 weist die Form einer dünnen, insbesondere runden Scheibe mit einer Dicke von z.B. 200 μm bis 1 mm auf.

**Patentansprüche**

1. Verfahren zum Betrieb eines Thyristors mit einem Halbleiterkörper, der einen von einer Kathode (5a, 5b) kontaktierten n-Emitter (1a, 1b) mit einer angrenzenden p-Basisschicht (2) und einen von einer Anode (6) kontaktierten p-Emitter (4) mit einer angrenzenden n-Basisschicht (3) aufweist, und mit an einer Grenzfläche (7) des Halbleiterkörpers angeordneten, als MIS-Strukturen ausgebildeten, steuerbaren Emitterkurzschlüssen (M1 bis M4), jeweils bestehend aus einem ersten Halbleitergebiet eines ersten Leitungstyps, das mit der den einen Emitter (1a, 1b) kontaktierenden Kathode (K) oder Anode elektrisch verbunden ist, einem mit der an diesen Emitter (1a, 1b) angrenzenden Basisschicht (2) elektrisch verbundenen zweiten Halbleitergebiet des ersten Leitungstyps und einem zwischen diesen Halbleitergebieten liegenden Halbleiterbereich eines zweiten Leitungstyps, der von einem gegenüber dem Halbleiterkörper elektrisch isolierten Gate (14) überdeckt ist, wobei der letztgenannte Emitter (1a, 1b) in eine Mehrzahl von Emittergebieten aufgeteilt ist, wobei eine Mehrzahl von MIS-Strukturen (M1 bis M4) jeweils randseitig zu den Emittergebieten (1a, 1b) angeordnet sind und die Gates (14, 15, 26, 27) über einen Steueranschluss (G) mit einem die Emitterkurzschlüsse aufhebenden Spannungsimpuls beschaltbar sind, wobei das erste Halbleitergebiet einer MIS-Struktur (M1) aus einem Randbereich eines Emittergebietes (1a) besteht, wobei das zweite Halbleitergebiet aus einem in die an dieses Emittergebiet (1a) angrenzende Basisschicht (2) eingefügten Kurzschlussgebiet (8) gebildet ist, das über eine leitende Belegung (16) mit dieser Basisschicht (2) verbunden ist, und wobei der von dem Gate (14) überdeckte Halbleiterbereich aus einem Teilbereich (10) der letztgenannten Basisschicht (2) besteht, der bis an die das Emittergebiet (1a) enthaltende Grenzfläche (7) des Halbleiterkörpers reicht, bei dem dem Steueranschluss (G) der randseitig zu den Emittergebieten (1a, 1b) angeordneten MIS-Strukturen (M1, M2) ein die Emitterkurzschlüsse während des Zündvorgangs aufhebender Spannungsimpuls (P1) zugeführt wird, und bei dem dieser Spannungsimpuls für den Fall, dass der genannte eine Emitter aus dem n-Emitter besteht, als negativer Impuls und für den Fall, dass der genannte eine Emitter aus dem p-Emitter besteht, als positiver Impuls zugeführt wird.

2. Verfahren zum Betrieb eines Thyristors mit einem Halbleiterkörper, der einen von einer Kathode (5a, 5b) kontaktierten n-Emitter (1a, 1b) mit einer angrenzenden p-Basisschicht (2) und einen von einer Anode (6) kontaktierten p-Emitter (4) mit einer angrenzenden n-Basisschicht (3) aufweist, und mit an einer Grenzfläche (7) des Halbleiterkörpers angeordneten, als MIS-Strukturen ausgebildeten, steuerbaren Emitterkurzschlüssen (M1 bis M4), jeweils bestehend aus einem ersten Halbleitergebiet eines ersten Leitungstyps, das mit der den einen Emitter (1a, 1b) kontaktierenden Kathode (K) oder Anode elektrisch verbunden ist, einem mit der an diesen Emitter (1a, 1b) angrenzenden Basisschicht (2) verbundenen zweiten Halbleitergebiet des ersten Leitungstyps und einem zwischen diesen Halbleitergebieten liegenden Halbleiterbereich eines zweiten Leitungstyps, der von einem gegenüber dem Halbleiterkörper elektrisch isolierten Gate (14) überdeckt ist, wobei der letztgenannte Emitter (1a, 1b) in eine Mehrzahl von Emittergebieten aufgeteilt ist, wobei eine Mehrzahl von MIS-Strukturen (M1 bis M4) jeweils randseitig zu den Emittergebieten (1a, 1b) angeordnet sind und die Gates (14, 15, 26, 27) über einen Steueranschluss (G) mit einem die Emitterkurzschlüsse aufhebenden Spannungsimpuls beschaltbar sind, wobei das erste Halbleitergebiet einer MIS-Struktur (M1) aus einem Randbereich eines Emittergebietes (1a) besteht, wobei das zweite Halbleitergebiet aus einem in die an dieses Emittergebiet (1a) angrenzende Basisschicht (2) eingefügten Kurzschlussgebiet (8) gebildet ist, das über eine leitende Belegung (16) mit dieser Basisschicht (2) verbunden ist, wobei der von dem Gate (14) überdeckte Halbleiterbereich aus einem Teilbereich (10) der zuletztgenannten Basisschicht (2) besteht, der bis an die das Emittergebiet enthaltende Grenzfläche (7) des Halbleiterkörpers reicht, wobei die zuletztgenannte Basisschicht (2) mit einer Zündelektrode (17) versehen ist, die einen Anschluss (Z) für einen Zündstromkreis aufweist, und wobei der Anschluss (Z) für den Zündstromkreis über eine Polaritätsumkehrschaltung (31, 37) mit dem Steueranschluss (G) der MIS-Strukturen (M1 bis M4) verbunden ist, bei dem eine am Anschluss (Z) für den Zündstromkreis bei Zuführung eines Zündstromimpulses abfallende Zündspannung umgepolt und dem Steueranschluss (G) der MIS-Strukturen (M1, M2) als ein die Emitterkurzschlüsse aufhebender Spannungsimpuls (P1) zugeführt wird.

## Claims

1. A method of operating a thyristor comprising a semiconductor body which includes an n-doped emitter (1a, 1b) contacted by a cathode (5a, 5b) and adjoined by a p-doped base layer (2), and a p-doped emitter (4) contacted by an anode (6) and adjoined by an n-doped base layer (3), and having controllable emitter short-circuits (M1 to M4) which consist of MIS-structures arranged at a boundary surface (7) of the semiconductor body, in each case consisting of a first semiconductor zone of a first conductivity type electrically-connected to the cathode (K) or anode which contacts the first emitter (1a, 1b), a second semiconductor zone of the first conductivity type electrically-connected to the base layer (2) which adjoins this emitter (1a, 1b), and a semiconductor zone of a second conductivity type located between the aforesaid semiconductor zones and covered by a gate (14) which is electrically-insulated from the semiconductor body, where the last-mentioned emitter (1a, 1b) is divided into a plurality of emitter zones, where a plurality of MIS-structures (M1 to M4) are each arranged laterally to the emitter zones (1a, 1b), and the gates (14, 15, 26, 27) can be connected via a control terminal (G) to receive a voltage pulse which cancels the emitter short-circuits, where the first semiconductor zone of a MIS-structure (M1) consists of an edge region of an emitter zone (1a), where the second semiconductor zone is formed by a short-circuit zone (8) which is formed in the base layer (2) which adjoins this emitter zone (1a) and connected via a conductive coating (16) to this base layer (2), and where the semiconductor zone covered by the gate (14) consists of a sub-zone (10) of the last-mentioned base layer (2) which extends to the boundary surface (7) of the semiconductor body which contains the emitter zone (1a), where the control terminal (G) of the MIS-structures (M1, M2) which are arranged laterally to the emitter zones (1a, 1b) are supplied with a voltage pulse (P1) which cancels the emitter short-circuits during the ignition process, and where this voltage pulse is supplied as a negative pulse in the event that the aforesaid first emitter is an n-doped emitter, and is supplied as a positive pulse in the event that the aforesaid first emitter is a p-doped emitter.

2. A method of operating a thyristor comprising a semiconductor body which includes an n-doped emitter (1a, 1b) contacted by a cathode (5a, 5b) and adjoined by a p-doped base layer (2), and a p-doped emitter (4) contacted by an anode (6) and adjoined by an n-doped base layer (3), and comprising controllable emitter short-circuits (M1 to M4) which consist of MIS-structures arranged at a boundary surface (7) of the semiconductor body and in each case consisting of a first semiconductor body of a first conductivity type electrically-connected to the cathode (K) or anode which contacts the first emitter (1a, 1b), a second semiconductor zone of the first conductivity type which is connected to the base layer (2) which adjoins this emitter (1a, 1b), and a semiconductor zone of a second conductivity type located between the aforesaid semiconductor zones and covered by a gate (14) electrically-insulated from the semiconductor body, where the last-mentioned emitter (1a, 1b) is divided into a plurality of emitter zones, where a plurality of MIS-structures (M1 to M4) are each arranged laterally to the emitter zones (1a, 1b) and the gates (14, 15, 26, 27) can be connected via a control terminal (G) to receive a voltage pulse which cancels the emitter short-circuits, where the first semiconductor zone of a MIS-structure (M1) consists of an edge region of an emitter zone (1a), where the second semiconductor zone is formed by a short-circuit zone (8) formed in the base layer (2) which adjoins this emitter zone (1a) and connected via a conductive coating (16) to this base layer (2), where the semiconductor zone covered by the gate (14) consists of a sub-zone (10) of the last-mentioned base layer (2) which extends to the boundary surface (7) of the semiconductor body which contains the emitter zone, where the last-mentioned base layer (2) is provided with an ignition electrode (17) which has a terminal (Z) for an ignition circuit, and where the terminal (Z) for the ignition circuit is connected via a polarity reversal circuit (31, 37) to the control terminal (G) of the MIS-structures (M1 to M4), where an ignition voltage lying at the terminal (Z) for the ignition circuit when an ignition current pulse is supplied, is reversed in polarity and supplied to the control terminal (G) of the MIS-structures (M1, M2) as a voltage pulse (P1) in order to cancel the emitter short-circuits.

## Revendications

1. Procédé pour faire fonctionner un thyristor comportant un corps semiconducteur, qui possède un émetteur de type n (1a, 1b) qui est en contact avec une cathode (5a, 5b) et est contigu à une couche de base (2) de type p, et un émetteur (4) de type p, qui est en contact avec une anode (6) et est contigu à une couche de base (3) de type n, et des courts-circuits d'émetteur commandables (M1 à M4), qui sont disposés au niveau d'une surface limite (7) du corps semiconducteur, sont réalisés sous la forme de structures MIS et sont constitués chacun par une première région semiconductrice possédant un premier type de conductivité, qui est reliée électriquement à la cathode (K) ou à l'anode, qui est en contact avec un émetteur (1a, 1b), par une seconde région semiconductrice qui est reliée électriquement à la couche de base (2) contiguë à cet émetteur (1a, 1b) et possède le premier type de conductivité et par une région semiconductrice possédant un second type de conductivité, qui est située entre ces régions semiconductrices et est recouverte par une grille (14) isolée du point de vue électrique par rapport au corps semiconducteur, et dans lequel l'émetteur (1a, 1b) mentionné en dernier lieu est subdivisé en une multiplicité de régions d'émetteur, une multiplicité de structures MIS (M1 à M4) sont disposées respectivement sur le bord des régions d'émetteur (1a, 1b) et les grilles (14, 15, 26, 27) peuvent recevoir par l'intermédiaire d'une borne de commande (G) au moyen d'une impulsion de tension supprimant les courts-circuits d'émetteur, et dans lequel la première région semiconductrice d'une structure MIS (M1) est constituée par une zone marginale d'une région d'émetteur (1a), et la seconde région semiconductrice est formée par une région de court-circuit (8), qui est insérée dans la couche de base (2) contiguë à cette région d'émetteur (1a) et est reliée par l'intermédiaire d'un revêtement conducteur (16) à cette couche de base (2), et dans lequel la région semiconductrice recouverte par la grille (14) est constituée par une région partielle (10) de la couche de base (2) indiquée en dernier lieu, qui s'étend jusqu'à la surface limite (7) contenant la région d'émetteur (1a), et selon lequel une impulsion de tension (P1) supprimant les courts-circuits d'émetteur pendant le processus d'amorçage est envoyée à la borne de commande (G) des structures MIS (M1, M2) disposées sur le bord des régions d'émetteur (1a, 1b), et selon lequel cette impulsion de tension est délivrée sous la forme d'une impulsion négative dans le cas où ledit émetteur est constitué par un émetteur de type n, et sous la forme d'une impulsion positive dans le cas où ledit émetteur est constitué par un émetteur de type p.

2. Procédé pour faire fonctionner un thyristor comportant un corps semiconducteur, qui possède un émetteur de type n (1a, 1b) qui est en contact avec une cathode (5a, 5b) et est contigu à une couche de base (2) de type p, et un émetteur (4) de type p, qui est en contact avec une anode (6) et est contigu à une couche de base (3) de type n, et des courts-circuits d'émetteur commandables (M1 à M4), qui sont disposés au niveau d'une surface limite (7) du corps semiconducteur, sont réalisés sous la forme de structures MIS et sont constitués chacun par une première région semiconductrice possédant un premier type de conductivité, qui est reliée électriquement à la cathode (K) ou à l'anode, qui est en contact avec un émetteur (1a, 1b), par une seconde région semiconductrice qui est reliée électriquement à la couche de base (2) contiguë à cet émetteur (1a, 1b) et possède le premier type de conductivité et par une région semiconductrice possédant un second type de conductivité, qui est située entre ces régions semiconductrices et est recouverte par une grille (14) isolée du point de vue électrique par rapport au corps semiconducteur, et dans lequel l'émetteur (1a, 1b) mentionné en dernier lieu est subdivisé en une multiplicité de régions d'émetteur, une multiplicité de structures MIS (M1 à M4) sont disposées respectivement sur le bord des régions d'émetteur (1a, 1b) et les grilles (14, 15, 26, 27) peuvent recevoir par l'intermédiaire d'une borne de commande (G) une impulsion de tension supprimant les courts-circuits d'émetteur, et dans lequel la première région semiconductrice d'une structure MIS (M1) est constituée par une zone marginale d'une région d'émetteur (1a), et la seconde région semiconductrice est formée par une région de court-circuit (8), qui est insérée dans la couche de base (2) contiguë à cette région d'émetteur (1a), et est reliée par l'intermédiaire d'un revêtement conducteur (16) à cette couche de base (2), et dans lequel la région semiconductrice recouverte par la grille (14) est constituée par une région partielle (10) de la couche de base (2) indiquée en dernier lieu, qui s'étend jusqu'à la surface limite (7) contenant la région d'émetteur (1a), et dans lequel la couche de base (2) indiquée en dernier lieu est équipée d'une électrode d'amorçage (17) qui comporte une borne (Z) pour un circuit d'amorçage et dans lequel la borne (Z) pour le circuit d'amorçage est reliée par l'intermédiaire d'un circuit (31, 37) d'inversion de la polarité à la borne de commande (G) des structures MIS (M1 à M4), et selon lequel la polarité d'une tension d'amorçage chutant au niveau de la borne (Z) prévue pour le circuit d'amorçage lors de l'envoi d'une impulsion de courant d'amorçage est inversée et cette tension d'amorçage inversée est envoyée en tant qu'impulsion de tension (P1) supprimant les courts-circuits d'émetteur à la borne de commande (G) des structures MIS (M1, M2).

# FIG 1

# FIG 2

# FIG 3

# FIG 4